# NEW EUROPEAN PATENT SPECIFICATION

(11) **EP 0 165 675 B2**
(45) Date of publication and mention of the opposition decision: **07.12.1994**
(45) Mention of the grant of the patent: 04.07.1990
(21) Application number: 85302879.3
(22) Date of filing: 24.04.1985
(51) Int. Cl.: G01N 25/00

(54) **Apparatus for measuring thermal stress of pressure-tight tube**
Vorrichtung zur Messung der thermischen Beanspruchung eines unter Druck stehenden Rohres
Appareil pour mesurer la contrainte thermique d'un tube sous pression

(30) Priority: 24.04.1984 JP 81158/84
(43) Date of publication of application: 27.12.1985
(73) Proprietor: BABCOCK-HITACHI KABUSHIKI KAISHA, Tokyo 100 (JP)
(72) Inventor: Kuramoto, Atsushi Kure Research Laboratory of, Kure-shi Hiroshima-ken (JP); Fukayama, Yukio Kure Research Laboratory of, Kure-shi Hiroshima-ken (JP); Kawano, Shigeyoshi Kure Research Laboratory of, Kure-shi Hiroshima-ken (JP)
(74) Representative: Pendlebury, Anthony

(56) References cited:
- EP-A- 0 122 578
- GB-A- 1 601 890

## Description

This invention relates to an apparatus for estimating thermal stress and in particular to such an apparatus wherein the thermal stress generated in parts of thermal equipment such as a boiler is monitored, while the load on the heating device is controlled so as to be maintained at an optimal value.

When a boiler is started or stopped or the operation thereof is changed, the load on the boiler changes accordingly and the fluid temperature can change greatly, such that there can be a large temperature difference between the metal part and the internal fluid.

The temperature difference generates thermal stress in the pressure part of the boiler. The thermal stress is particularly high in a corner portion of a nozzle in a thick-walled pressure part, such as the outlet header of a secondary superheater, so that the life of the thick-walled pressure part is shortened by low cycle fatigue.

Even during steady-stage operation, the internal pressure stress due to internal fluid, causes creep damage of the thick-walled pressure part that accumulates.

The thermal stress generated in a thick-walled tube of the pressure part of the boiler has heretofore been estimated from the distribution of temperature in the direction of the wall thickness. The following methods of estimating the distribution of temperature have been used in the past.
(1) The first one of the methods is based on an actual measured value of internal fluid temperature for estimating an inner surface metal temperature, and on a perfect thermal insulation condition for estimating an outer surface metal temperature. Using these conditions, non-stationary heat transfer equations are solved to obtain the temperature distribution of the metal part in the direction of thickness, and the thermal stress is calculated. However, in this method, it is necessary to estimate the heat transfer coefficient between the internal fluid and the inner metal surface exactly. Usually, a constant value is used as the heat transfer coefficient because of the difficulty of the exact estimation. Then the estimation accuracy of the temperature distribution in the metal is not satisfactory.
(2) Temperatures are measured on two points close to the outer surface and the inner surface of the thick-walled metal part. The distribution of temperature in a direction of the wall thickness is approximated by a straight line between these two points thereby to measure the stress generated.

The following disadvantages are present in the known method wherein the distribution of temperature in the direction of the wall thickness is measured, and the stress generated is estimated on the basis of the distribution of temperature thus measured.
(1) The boundary condition at the outer surface of the metal is assumed to be adiabatic. However, in practice, radiation occurs although it is small.
   Further, it is unreasonable to contemplate improving the accuracy of measurement of the stress generated because the coefficient of heat-transfer, for the boundary condition at the inner surface of the metal, greatly changes due to the internal flow rate of the fluid and/or evaporation conditions.
(2) When the distribution of temperature in the direction of the wall thickness is approximated by a straight line, the stress generated is underestimated so as to be lower than the actual stress generated.

The temperature distribution and the stress have heretofore been calculated at predetermined intervals of time in respective calculation cycles irrespective of changes in the internal fluid temperature and the stress generated in the thick-walled tube is estimated from the distribution of temperature in the direction of the wall thickness.

The following disadvantages are presented by the method of estimating the stress generated in which the calculated cycles have been carried out at predetermined intervals of time as described above.
(1) All of the operating conditions of a plant are assumed and the calculation cycles are determined so that the stress generated can be accurately estimated under an operating state where the change is largest.
   In other words, even during steady-state operation where fluctuations in the fluid temperature are small, the generated stress is estimated by using the same calculation cycles as those used to estimate the stress at the start, stop or change of load of the plant so that the accuracy of estimation is considered to be excessive at the time of steady-state operation.
(2) In general, at the time of the start-up, stopping or change of load of a power plant, if the plant is controlled by a computer, the load on the computer is very large so that the estimation of the stress generated by carrying out calculation cycles at predetermined intervals of time irrespective of the state of the plant is regarded as one of the causes of the increase in the load which is imposed on the computer.

The present invention has been developed to obviate the above-described disadvantages of the prior art and has as an object the provision of an apparatus for estimating thermal stress, wherein the distribution of temperature in the direction of the wall thickness of a pressure part, which is used in thermal equipment such as a boiler, is estimated with high accuracy, so that the stress generated can be measured to be a value which is close to the actual state.

The present invention accordingly provides (in respect of the states GB, NL) an apparatus for measuring thermal stress in a pressure-tight tube, comprising:
a temperature distribution calculator for calculating the distribution of temperature at positions equidistantly arranged in a direction along the thickness of said tube on the basis of measured values on the surfaces of a metal portion of said tube; and
a thermal stress calculator for calculating the thermal stress of the metal portion of said tube.

It is a further object of the present invention to provide an apparatus for measuring thermal stress, wherein the calculation cycles are varied according to whether the load on the heating device, such as a boiler, is changing or is in steady-state operation, so that the measured value of the stress generated is close to the actual state.

Accordingly, it is preferable that the present invention is of such an arrangement that there is provided a calculation cycle setter for presetting the calculation cycles on the basis of measured values of temperature of the fluid from the pressure-tight tube, the calculation cycles are made short at the time of change in pressure where fluctuations in the measured value of the fluid temperature are large, and the calculation cycles are made long at the time of the steady operation where fluctuations in the measured value of the fluid temperature are small.

A method of monitoring fatigue of a stressed structual component part is disclosed in EP-A2-0122578, which constitutes part of the state of the art by virtue of Article 54(3) EPC in respect of the common states DE, IT. The method involves detecting the external temperature of the component at various positions and over a period of time, utilising a regressive temperature analysis to calculate the temperature distribution, from which the stress distribution can be derived.

According to the present invention in respect of the states DE and IT there is provided an apparatus for measuring thermal stress in a pressure-tight tube, comprising:
a temperature distribution calculator adapted to calculate the distribution of temperature at positions equidistantly arranged in a direction along the thickness of said tube on the basis of measured values of the temperature, pressure and flowrate of a fluid flowing in said tube, and a measured value of the outer surface temperature of the metal of said tube; and
a thermal stress calculator for calculating the thermal stress of the metal portion of said tube on the basis of the calculated distribution of temperature.

The present invention is preferably applicable to a pressure-tight tube which is incorporated in a boiler, a heating furnace, a cracker or the like, in which fluid is heated. Description will hereunder be given of a boiler embodying the present invention.

An embodiment of the present invention will now be described by way of example only with reference to the accompanying drawings, in which:-
Fig. 1 is a schematic flow chart of the system for measuring thermal stress of a boiler embodying the present invention (in respect of the states GB, NL);
Fig. 2 is a view showing in detail the header which is shown in Fig. 1;
Fig. 3 is an enlarged sectional view taken along the line X-X in Fig. 2, showing a part of a cylindrical model for calculating the distribution of temperature;
Fig. 4 is a diagram showing the relationship between the fluid temperature and the calculation cycle over a period of time.

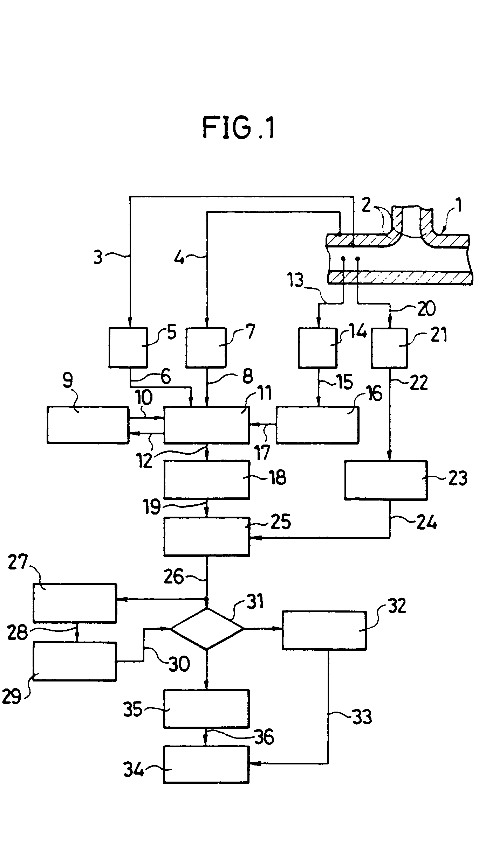

First, description will be given of the outline of the system for estimating the thermal stress in a boiler with reference to Fig. 1.

As a typical example of a thermal stress monitoring point in a boiler, a nozzle corner portion 2 of a header 1 of a superheater will be described.

The header 1 has a thick wall, and is used in high temperature conditions close to 550°C. A difference in temperature between the inner and the outer surfaces of the header 1 occurs in accordance with changes in the fluid temperature and in the flowrate in the header 1 when the load on the boiler is changed such as when the boiler is started or stopped. Particularly, the nozzle corner portion 2, being complicated in construction, has a correspondingly complicated distribution of generated stress and the stress is relatively high. The nozzle corner portion 2 is a portion where thermal stress is generated to a large degree.

Furthermore, the pressure of the internal fluid at the time of steady-state operation can be as high as 255 Kg/cm², at which the deterioration of the boiler due to the stress resulting from the internal pressure is also high.

In order to estimate the thermal stress at the various monitoring points on the boiler, initially, signals 3 and 4 relating to the metal temperature at the inner surface and the outer surface respectively of the header 1 are generated. From those signals, a measured value 6 of the inner surface temperature of the metal is outputted by a metal inner surface temperature detector 5, and a measured value 8 of the outer surface temperature of the metal is outputted by a metal outer surface temperature detector 7. A calculated value 12 of the distribution of temperature in the direction of the metal thickness is calculated by a temperature distribution calculator 11 on the basis of the both measured values 6, 8 and a value 10 of the temperature distribution is outputted from a temperature distribution storing device 9.

For presetting a calculation cycle for estimating the generated stress, a signal 13 relating to the fluid temperature is generated from the interior of the header 1 and is detected by a fluid temperature detector 14 which outputs a measured value 15 of the fluid temperature. In a calculation cycle setter 16, the rate of change of the fluid temperature is determined from the measured value 15 of the fluid temperature. The rate of change of the fluid temperature is compared with predetermined ranges of the change rate of the fluid temperature, and classified. A preset value 17 of the calculation cycle is thereby preset, which corresponds to a respective one of the range of the plurality of rates of change in the fluid temperature.

The calculated value 12 of the distribution of temperature in the direction of the metal thickness is stored in the temperature distribution storing device 9, and is fed to a thermal stress calculator 18 to calculate a value 19 of the thermal stress.

A signal 20 relating to the pressure is detected from the header 1 by a pressure detector 21, and a calculated value 24 of the internal stress is produced by an internal stress calculator 23 from a measured value 22 of the steam pressure which is emitted by the pressure detector 21.

In a current stress calculator 25, a calculated value 24 of the internal pressure which is obtained from the measured value 22 of the steam pressure which is detected by the pressure detector 21 is added to the calculated value 19 of the thermal stress which is obtained from the calculated value 12 of the distribution of temperature in the direction of the metal thickness, thereby to obtain a calculated value 26 of the current stress.

In an expired lifetime calculator 27, a value 28 of the amount of the life of the apparatus which has expired due to fatigue and creep is calculated on the basis of the calculated value 26 of the current stress. In a stress limit value presetter 29, the calculated value 28 of the expired lifetime of the apparatus in operation is subtracted from a value of the life expectancy of the design which has been determined at the time of planning, taking into account every monitoring point and every operation mode, thereby to calculate the remaining life of the plant. Further, from the remaining life and remaining operation cycles, an allowable life consumption per future operation mode is determined, and the corresponding stress which would be generated, which is expected to bring about the life consumption, is preset as a preset value 30 of the stress limit of the header 1.

The preset value 30 of the stress limit from the stress limit preset value setter 29 is adapted to be renewed with every desired start/stop cycle of the plant.

The calculated value 26 of the current stress is compared with the preset value 30 of the stress limit in a comparator 31.

When the calculated value 26 of the current stress exceeds the preset value 30 of the stress limit, a load hold signal 33 is generated in a load hold signal generator 32 and delivered to a boiler load controller 34.

When the calculated value 26 of the current stress is lower than the preset value 30 of the stress limit, an optimal rate of change in load (rate of change in fuel and rate of change in pressure) of the boiler, is selected from several predetermined load changing rates by a load change rate presetter 35 as a preset value 36 of the load change rate.

As described above, in the system for estimating thermal stress according to the present invention, the nozzle corner portion 2 is noted as being a stress concentrated portion in the header 1 in fig. 1, and the generated stress and the life consumption are monitored. In this case, the measured value 15 of the fluid temperature is detected by the fluid temperature detector 14 in predetermined sample cycles.

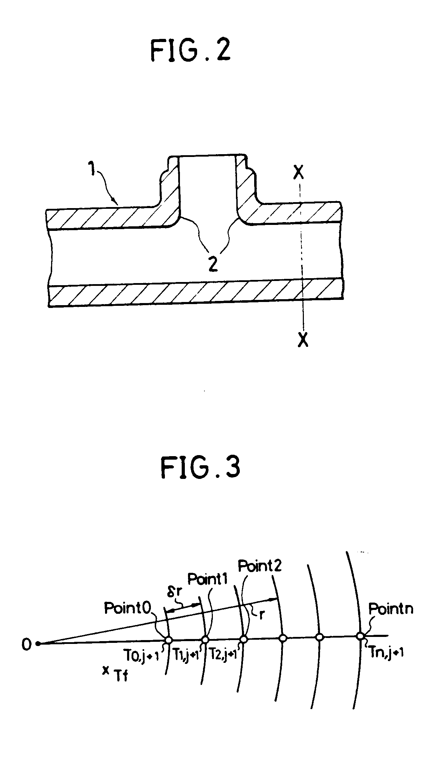

The following gives a detailed description of the temperature distribution calculator 11 in Fig. 1 and Fig. 3 is an enlarged sectional view taken along the line X-X in Fig. 2, showing a part of a cylindrical model for calculating the distribution of temperature.

Thermal stress in a cylindrical portion is obtained from the distribution of temperature in the direction of the thickness of the cylindrical portion. The distribution of temperature is determined from the following equation (1) of heat transmission in cylindical coordinates. The cylindrical portion is divided by n elements, which are cylinders concentric with one another, with grid points being disposed at regular intervals along the radius of the cylinder, and equation (1) is solved by the finite differential method. 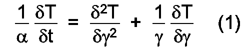 where
a: thermal conductivity of metal,
T: metal temperature at the coordinate point (y,O,z) t: time, and
y: distance from the centre of the cylinder.

A differential equation is represented by equation (2), and equations corresponding to the respective grid points are obtainable as equations (3).

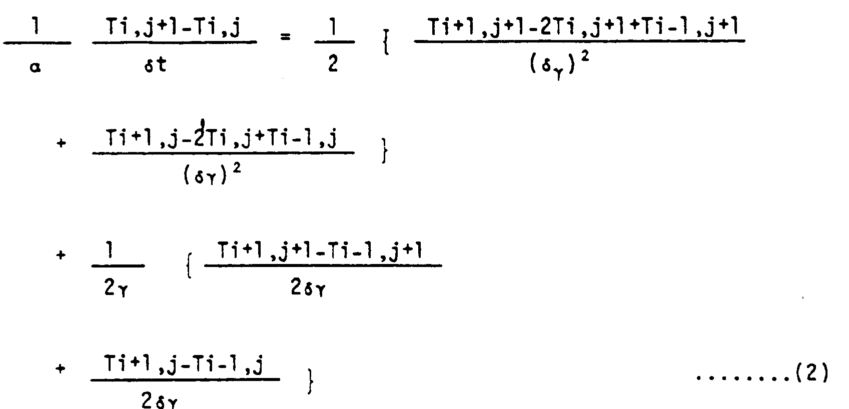

For the grid point 1:

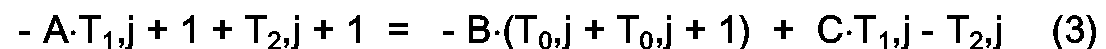

For the arid ooint 2

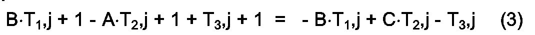

For the grid point 3:

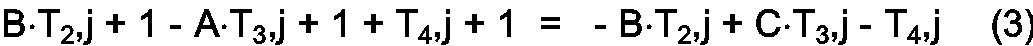

For the grid point n-1:

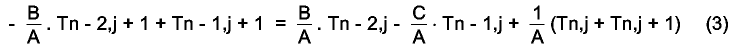

Here, 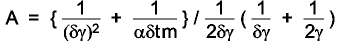 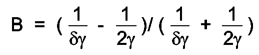 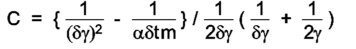 where
Ti,j: metal temperature (i: grid point number,
   j: time division number),
Tₒ,j: inner surface temperature of metal, measured value 6 in Fig. 1,
Tn,j: outer surface temperature of metal, measured value 8 in Fig. 1,
8y: portion of radial thickness, and
8t = 8tm: calculation cycle (s) (m = 1-M).
A, B, C: time-independent coefficients of equation (3), but function of position r, split with 8r and time division 8tm.

In equations (3), the right hand terms are composed only with known variables, which are T_{N,J} (N = 1 to n-1) calculated in the previous calculation cycle, Tₒ,ⱼ and T_{n,j} measured in the previous cycle, and T_{0,j+1} and T_{n,j+1} measured in the current computation cycle.

The left hand of equation (3) is composed with unknown variables, T_{N,j+1} (N = 1 to n-1) which mean the current temperature distribution on the grid points.

Equations (3) can be solved by the linear matrix calculation, because the number of equations (3) is the same as the number of unknown quantities T_{N,j+1} (N = 1 to n-1). Boundary values Tₒj+1, Tn, j+1 are the temperatures of the inner and outer surfaces of the metal, and given by the measured value 6 of the inner surface temperature of the metal and the measured value 8 of the outer surface temperature of the metal, respectively. In consequence, the calculated value 12 of the distribution of temperature in the metal thickness, i.e. T_{N}, j+1 (N = 0, 1,2,...n) is obtainable and calculable. The thermal stresses are calculated by thermal stress calculator 18 as follows. The thermal stresses in the three directions σrt, σθt and αzt can be determined by the following equations. 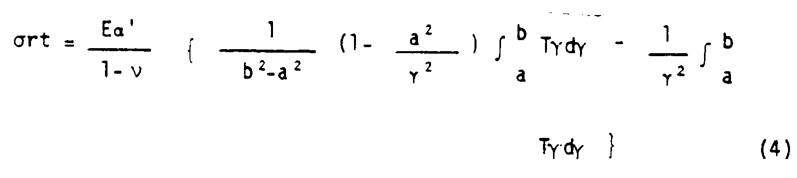 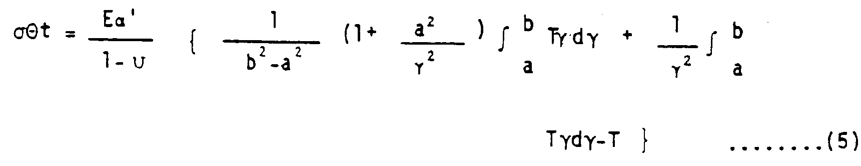 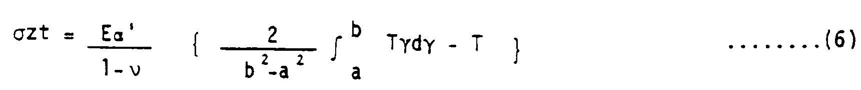 where
σrt: thermal stress in the radial direction,
E: Young's modulus of elasticity,
σθt: thermal stress in the circumferential direction,
a': coefficient of thermal expansion,
azt: thermal stress in the axial direction, and
v: Poisson's ratio.

Next, the stresses in the three directions due to the internal pressure are obtainable through the following equations: 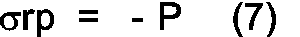 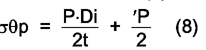 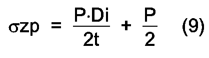 wnere
arp: stress of internal pressure in the radial direction,
P: internal pressure,
σθp: stress of internal pressure corresponding to measured value 22, in the circumferential direction, Di: internal diameter,
azp: internal surface stress in the axial direction, and
t: cylinder thickness.

The above-mentioned equations (4) through (9) represent stresses generated in a cylindrical portion of a boiler header, which is calculated by current stress calculator 25. The stress generated in the stress concentrated portion such as the nozzle corner portion 2 is obtained by multiplying the stress generated in the cylindrical portion by a stress concentration factor. In consequence, the stresses in the three directions of the current stress calculated value 26 generated in the nozzle corner portion 2 are obtainable through the equations (10) to(12). 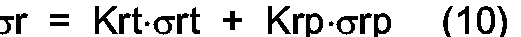 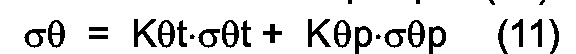 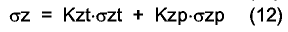 where
Krt: radial thermal stress concentration factor,
KOt: circumferential thermal stress concentration factor,
Kzt: axial thermal stress concentration factor,
Krp: radial internal pressure stress concentration factor,
KOp: circumferential internal pressure stress concentration factor,
Kzp: axial internal pressure stress concentration factor,
ar: radial total stress,
α0: circumferential total stress, and
az: axial total stress.

The distribution of temperature in the direction of the thickness in the pressure part of the boiler in the prior art has heretofore been estimated by calculating the distribution of temperature using a linear approximation from the metal inner and outer surface measured values 6 and 8. In this case, if the actual distribution of temperature in the direction of metal thickness is represented by a curve, the estimating accuracy of the generated stress is reduced.

Now, when the system for estimating the thermal stress according to the present invention is used, a partial differential equation is solved, and calculations can be made at suitable intervals of time to determine the distributions of temperature at the respective grid points, whereby the accuracy thereof is higher than with the conventional system, so that the generated stress can be reliably determined.

Furthermore, the thermal stress estimating calculations can be performed in real time within the temperature measuring interval, during which changes in temperature can be satisfactorily taken into account, so that changes in the distribution of temperature can be determined in a short period of time thereby enabling the generated stress to be estimated with high accuracy.

In the following case, the boundary condition of the inner surface of the metal (metal inner surface temperature) is determined from the coefficient of heat-transfer of the fluid in contact with the interior of the tube. To determine the thermal stress at the monitoring point on the pressure part of the boiler, a measured value of the steam temperature is detected by a steam temperature detector, a measured value of the steam flowrate is detected by a steam flowrate detector and a measured value of the steam pressure is detected by the pressure detector. On the basis of these values, the coefficient of heat transfer from the steam to the metal is calculated in a heat-transfer coefficient calculator. Subsequently, the distribution of temperature in the metal may be obtained by the temperature distribution calculator. The equation (1) of the heat conduction of the cylinder is solved, with the following equation being taken as the boundary condition for the inner surface of the metal. Thus the distribution of temperature in the metal is thereby obtained. 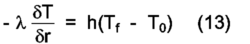 where
T_{f}: fluid temperature, and
To: inner surface temperature of metal.

In the system as shown in Fig. 1, in the estimated calculation method of the distribution of temperature, the calculation is made on the basis of the measured values of the inner and outer surface temperatures of the metal. However, in the portions where high accuracy of estimation of the generated stress is not required, the generated stress may be determined from the temperature, pressure and flowrate of the fluid and the temperature of the outer surface of the metal, as required by the invention which is the subject of the claims for the states DE, IT.

In the embodiment shown in Fig. 1, only one thermal stress monitoring point has been used. However, in practice, a plurality of such monitoring points as described above are provided, thus providing a method of operating the boiler, wherein all the requirements are satisfied.

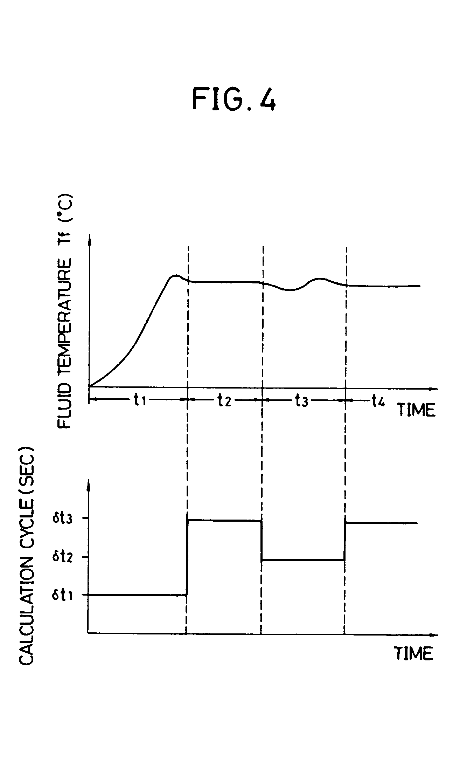

Description will hereunder be given of the method of presetting the calculation cycle preset value 17 with reference to Fig. 4. Fig. 4 shows an example of changes in the fluid temperature from the start of the boiler to steady-state operation. Fig. 4 shows that, at the time t₁ of a change in the load such as the start of the boiler, where fluctuations in the fluid temperature are large, a calculation cycle ot₁ is preset. At the times t₂ and t₄ of steady-state operation where any fluctuations in the fluid temperature are small, a calculation cycle 8t₃ is preset. At the time t₃ of an intermediate change in the fluid temperature, a calculation cycle 8t₂ is preset. In the practical system, an absolute value Δ I Tf of the rate of change in the temperature is determined by use of the measured values 15 of the fluid temperature for detecting the fluid temperature at predetermined sample cycles. In the calculation cycle setter 16, the preset value 17 of the calculation cycle corresponding to the absolute Δ |T_{f} is preset.

When this method is adopted, the calculation cycle for estimating the generated stress during the time period of monitoring the stress can be altered in accordance with the operating conditions of the boiler, whereby any useless calculation can be dispensed with, so that the load imposed upon the computer can be reduced. Furthermore, over the whole of the time period of monitoring the stress, the generated stress can be estimated in optimal calculation cycles, so that the load imposed upon the computer can be reduced accordingly. For example, in Fig. 4, at the time of steady-state operation where fluctuations in the fluid temperature are small, the generated stress is estimated in the calculation cycle 8t₂ or 8t₃. In contrast, at the time of the start of the boiler where the load is changed, the generated stress is estimated in the calculation cycle ot₁, whereby, at the time of steady-state operation, the calculations are made once for every two cycles or three cycles of the calculation cycle ot₁, so that the load imposed upon the computer can be decreased a factor of 2 or 3.

When the load of the computer is reduced as described above, the computer can be further utilized, in performing calculations for other purposes of control or in adding a new function or functions. This results in economical use of the computer.

Since, in the predetermined calculation cycles, the generated stress can be estimated with high accuracy when the boiler is under a full load, useless calculations are made at the time of steady-state operation, etc. of the boiler, resulting in excessive accuracy. In consequence, according to the present invention, when the load is changed such as during the start-up or stopping of the boiler when the fluid temperature fluctuates greatly, the calculation cycles are short, while during steady-state operation, etc., when changes in the fluid temperature are small, the calculation cycles are long, so that over the total time period of stress monitoring, the generated stress can be estimated with uniform accuracy.

From the measured value of the fluid temperature in a pressure-tight tube portion of a heating device such as a boiler, the distribution of temperature in the direction of the metal thickness can be measured with high accuracy and the stress generated can be reliably measured. Furthermore, there is provided a calculation cycle setter for presetting the calculation cycles in accordance with the measured values of the fluid temperature, whereby, when the load changes and the fluid temperature fluctuates greatly, the calculation cycles are short, while, during steady-state operation when the fluctuations of the fluid temperature are small, the calculation cycles are long, so that the calculation cycles for estimating the generated stress can be altered in accordance with the operating conditions of the heating device. Moreover, the generated stress can be measured at a value close to the actual state.

## Claims (Claims for the following Contracting State(s) : DE, IT)

1. An apparatus for measuring thermal stress in a pressure-tight tube (1), comprising:
a temperature distribution calculator (11) adapted to calculate the distribution of temperature at positions equidistantly arranged in a direction along the thickness of said tube (1) on the basis of measured values of the temperature, pressure and flowrate of a fluid flowing in said tube, and a measured value (8) of the outer surface temperature of the metal of said tube; and
a thermal stress calculator (18) for calculating the thermal stress of the metal portion of said tube (1) on the basis of the calculated distribution of temperature.

2. An apparatus according to claim 1, wherein said pressure-tight tube (1) is provided on a boiler.

3. An apparatus according to any foregoing claim further comprising a calculation cycle setter (16) for presetting calculation cycles on the basis of measured values (15) of the fluid temperature in said pressure-tight tube (1); wherein said calculation cycles are made short when fluctuations in the measured values of the fluid temperature are large, while, said calculation cycles are made long when fluctuations in the measured values of the fluid temperature are small.

4. A method of measuring thermal stress in a pressure-tight tube (1), the method comprising the steps of calculating the distribution of temperature at positions equidistantly arranged in a direction along the thickness of said tube (1) on the basis of measured values of the temperature, pressure and flowrate of a fluid flowing in said tube, and a measured value of the outer surface temperature of the metal portion of said tube (1); and calculating the thermal stress of the metal portion of said tube on the basis of the calculated distribution of temperature.

5. A method according to claim 4, wherein said pressure-tight tube is provided on a boiler.

6. A method according to claim 4 or 5 further comprising the step of presetting calculation cycles on the basis of measured values (15) of the fluid temperature in said pressure-tight tube; wherein said calculation cycles are made short when fluctuations in the measured values of the fluid temperature are large, while, said calculation cycles are made long when fluctuations in the measured values of the fluid temperature are small.

## Claims (Claims for the following Contracting State(s) : GB, NL)

1. An apparatus for measuring thermal stress in a pressure-tight tube, comprising:
a temperature distribution calculator for calculating the distribution of temperature at positions equidistantly arranged in a direction along the thickness of said tube on the basis of measured values on the surfaces of a metal portion of said tube; and
a thermal stress calculator for calculating the thermal stress of the metal portion of said tube.

2. An apparatus according to Claim 1, wherein said measured values are measured values of the inner and outer surface temperatures of the metal of said tube.

3. An apparatus according to Claim 1, wherein said measured values are measured values of the temperature, pressure and flowrate of the fluid in said tube, and a measured value of the outer surface temperature of the metal of said tube.

4. An apparatus according to Claim 1, 2 or 3, wherein said pressure-tight tube is provided on a boiler.

5. An apparatus according to any foregoing claim further comprising a calculation cycle setter for presetting calculation cycles on the basis of measured values of the fluid temperature in said pressure-tight tube; wherein said calculation cycles are made short when fluctuations in the measured values of the fluid temperature are large, while, said calculation cycles are made long when fluctuations in the measured values of the fluid temperature are small.

6. A method of measuring thermal stress in a pressure-tight tube, the method comprising the steps of calculating the distribution of temperature at positions equidistantly arranged in a direction along the thickness of said tube on the basis of measured values on the surfaces of a metal portion of said tube; and calculating the thermal stress of the metal portion of said tube.

7. A method according to Claim 6, wherein said measured values are measured values of the inner and outer surface temperatures of the metal of said tube.

8. A method according to Claim 6, wherein said measured values are measured values of the temperature, pressure and flowrate of the fluid in said tube, and a measured value of the outer surface temperature of the metal of said tube.

9. A method according to Claim 6, 7 or 8, wherein said pressure-tight tube is provided on a boiler.

10. A method according to any one of Claims 6 to 9 further comprising the step of presetting calculation cycles on the basis of measured values of the fluid temperature in said pressure-tight tube; wherein said calculation cycles are made short when fluctuations in the measured values of the fluid temperature are large, while, said calculation cycles are made long when fluctuations in the measured values of the fluid temperature are small.

## Patentansprüche (Patentansprüche für folgende(n) Vertragsstaat(en) : DE, IT)

1. Vorrichtung zur Messung der thermischen Beanspruchung eines druckdichten Rohrs (1), bestehend aus: einem Temperaturverteilungs-Rechner (11), der zum Berechnen der Temperaturverteilung an abstandsgleich gelegenen Stellen längs der Dicke des Rohrs (1) aufgrund von gemessenen Werten der Temperatur, des Drucks und der Strömungsgeschwindigkeit eines in dem Rohr strömenden Mediums sowie eines gemessenen Werts (8) der Temperatur des Rohrmetalls an der Außenfläche; und
einem Wärmebeanspruchungs-Rechner (18) zum Berechnen der thermischen Beanspruchung des Metallteils des Rohrs (1) aufgrund der berechneten Temperaturverteilung.

2. Vorrichtung nach Anspruch 1, wobei das unter Druck stehende Rohr (1) an einem Kessel vorgesehen ist.

3. Vorrichtung nach einem der vorangehenden Ansprüche, außerdem bestehend aus einer Berechnungszyklus-Einstelleinrichtung (16) zur Voreinstellung des Berechnungszyklus aufgrund von Meßwerten (15) der Temperatur des Mediums in dem druckdichten Rohr (1); wobei der Berechnungszyklus kurz gewählt wird, wenn die Schwankungen der Meßwerte für den Druck des Mediums groß sind, wogegen der Berechnungszyklus lang gewählt wird, wenn die Schwankungen der Meßwerte für den Druck des Mediums gering sind.

4. Verfahren zur Messung der thermischen Beanspruchung eines druckdichten Rohrs (1), bestehend aus den Schritten der Berechnung der Temperaturverteilung an abstandsgleich gelegenen Stellen längs der Dicke des Rohrs (1) aufgrund von gemessenen Werten der Temperatur, des Drucks und der Strömungsgeschwindigkeit eines in dem Rohr strömenden Mediums sowie eines gemessenen Werts derTemperatur an der Außenfläche des Metallteils des Rohrs (1); und der Berechnung der thermischen Belastung des Metallteils des Rohrs aufgrund der berechneten Temperaturverteilung.

5. Verfahren nach Anspruch 4, wobei das druckdichte Rohr an einem Kessel vorgesehen ist.

6. Verfahren nach Anspruch 4 oder 5, außerdem bestehend aus dem Schritt der Voreinstellung des Berechnungszyklus aufgrund von Meßwerten (15) der Temperatur des Mediums in dem druckdichten Rohr; wobei der Berechnungszyklus kurz gewählt wird, wenn die Schwankungen der Meßwerte für den Druck des Mediums groß sind, wogegen der Berechnungszyklus lang gewählt wird, wenn die Schwankungen der Meßwerte für den Druck des Mediums gering sind.

## Patentansprüche (Patentansprüche für folgende(n) Vertragsstaat(en) : GB, NL)

1. Vorrichtung zur Messung der thermischen Beanspruchung eines unter Druck stehenden Rohres, bestehend aus:
einem Temperaturverteilungs-Rechner zum Berechnen der Temperaturverteilung an abstandsgleich gelegenen Stellen längs der Dicke des Rohres aufgrund von an den Flächen eines Metallteils des Rohres gemessenen Werten; und
einem Wärmebeanspruchungs-Rechner zum Berechnen der thermischen Beanspruchung des Metallteils des Rohres.

2. Vorrichtung nach Anspruch 1, wobei die gemessenen Werte Meßwerte der Temperaturen der Innen- und Außenflächen des Metalls des Rohres sind.

3. Vorrichtung nach Anspruch 1, wobei die gemessenen Werte Meßwerte von Temperatur, Druck und Strömungsgeschwindigkeit des Mediums im Rohr sowie ein Meßwert der Temperatur der Außenfläche des Metalls des Rohres sind.

4. Vorrichtung nach Anspruch 1, 2 oder 3, wobei das unter Druck stehende Rohr an einem Kessel vorgesehen ist.

5. Vorrichtung nach einem der vorangehenden Ansprüche, außerdem bestehend aus einer Berechnungszyklus-Einstelleinrichtung zur Voreinstellung des Berechnungszyklus aufgrund von Meßwerten der Temperatur des Mediums in dem unter Druck stehenden Rohr; wobei der Berechnungszyklus kurz gewählt wird, wenn die Schwankungen der Meßwerte für den Druck des Mediums groß sind, wogegen der Berechnungszyklus lang gewählt wird, wenn die Schwankungen der Meßwerte für den Druck des Mediums gering sind.

6. Verfahren zur Messung der thermischen Beanspruchung eines unter Druckstehenden Rohres, bestehend aus den Schritten der Berechnung der Temperaturverteilung an abstandsgleich gelegenen Stellen längs der Dicke des Rohres aufgrund von an den Flächen eines Metallteils des Rohres gemessenen Werten; und der Berechnung der thermischen Beanspruchung des Metallteils des Rohres.

7. Verfahren nach Anspruch 6, wobei die gemessenen Werte Meßwerte der Temperaturen der Innen- und Außenflächen des Metalls des Rohres sind.

8. Verfahren nach Anspruch 6, wobei die gemessenen Werte Meßwerte von Temperatur, Druck und Strömungsgeschwindigkeit des Mediums im Rohr sowie ein Meßwert der Temperatur der Außenfläche des Metalls des Rohres sind.

9. Verfahren nach Anspruch 6, 7 oder 8, wobei das unter Druck stehende Rohr an einem Kessel vorgesehen ist.

10. Verfahren nach einem der Ansprüche 6 bis 9, außerdem bestehend aus dem Schritt der Voreinstellung des Berechnungszyklus aufgrund von Meßwerten der Temperatur des Mediums in dem unter Druck stehenden Rohr; wobei der Berechnungszyklus kurz gewählt wird, wenn die Schwankungen der Meßwerte für den Druck des Mediums groß sind, wogegen der Berechnungszyklus lang gewählt wird, wenn die Schwankungen der Meßwerte für den Druck des Mediums gering sind.

## Revendications (Revendications pour l'(les) Etat(s) contractant(s) suivant(s) : suivants : DE, IT)

1. Appareil de mesure d'une contrainte thermique dans un tube soumis à une pression (1), comportant :
un calculateur de répartition de température (11) adapté à calculer la répartition de la température en des emplacements équidistants dans une direction le long de l'épaisseur dudit tube (1) en fonction de valeurs mesurées de la température, de la pression et du débit d'un fluide circulant dans ledit tube, et d'une valeur mesurée (8) de la température superficielle externe du métal dudit tube; et
un calculateur de contrainte thermique (18) pour calculer la contrainte thermique de la partie de métal dudit tube (1) en fonction de la répartition de la température calculée.

2. Appareil selon la revendication 1, dans lequel ledit tube soumis à une pression (1) est situé sur une chaudière.

3. Appareil selon l'une quelconque des revendications précédentes, comportant en outre un organe de fixation de cycles de calculs (16) en vue de prédéterminer des cycles de calcul en fonction de valeurs mesurées (15) de la température du fluide dans ledit tube soumis à une pression (1); dans lequel lesdits cycles de calcul sont raccourcis lorsque des fluctuations des valeurs mesurées de la température du fluide sont importantes, tandis que lesdits cycles de calcul sont allongés lorsque des fluctuations des valeurs mesurées de la température du fluide sont faibles.

4. Procédé de mesure d'une contrainte thermique dans un tube soumis à une pression (1), le procédé comportant les étapes consistant à calculer la répartition de température en des emplacements équidistants dans une direction le long de l'épaisseur dudit tube (1) en fonction de valeurs mesurées de la température, de la pression et du débit d'un fluide circulant dans ledit tube, et d'une valeur mesurée de la température superficielle externe de la partie de métal dudit tube (1); et calculer la contrainte thermique de la partie de métal dudit tube en fonction de la répartition de la température calculée.

5. Procédé selon la revendication 4, dans lequel ledit tube soumis à une pression est situé sur une chaudière.

6. Procédé selon la revendication 4 ou 5, comportant en outre l'étape consistant à prédéterminer des cycles de calcul en fonction de valeurs mesurées (15) de la température du fluide dans ledit tube soumis à une pression; dans lequel lesdits cycles de calcul sont raccourcis lorsque des fluctuations des valeurs mesurées de la température du fluide sont importantes, tandis que lesdits cycles de calcul sont allongés lorsque des fluctuations des valeurs mesurées de la température du fluide sont faibles.

## Revendications (Revendications pour l'(les) Etat(s) contractant(s) suivant(s) : suivants : GB, NL)

1. Appareil de mesure d'une contrainte thermique dans un tube soumis à une pression, comportant :
un calculateur de répartition de température pour calculer la répartition de la température en des emplacements équidistants dans une direction le long de l'épaisseur dudit tube en fonction de valeurs mesurées sur les surfaces d'une partie de métal dudit tube; et
un calculateur de contrainte thermique pour calculer la contrainte thermique de la partie de métal dudit tube.

2. Appareil selon la revendication 1, dans lequel lesdites valeurs mesurées sont des valeurs mesurées des températures superficielles internes et externes du métal dudit tube.

3. Appareil selon la revendication 1, dans lequel lesdites valeurs mesurées sont des valeurs mesurées de la température, de la pression et du débit du fluide dans ledit tube, et une valeur mesurée de la température superficielle externe du métal dudit tube.

4. Appareil selon la revendication 1, 2 ou 3 dans lequel ledit tube soumis à une pression est situé sur une chaudière.

5. Appareil selon l'une quelconque des revendications précédentes, comportant en outre un organe de fixation de cycles de calculs en vue de prédéterminer des cycles de calcul en fonction de valeurs mesurées de la température du fluide dans ledit tube soumis à une pression; dans lequel lesdits cycles de calcul sont raccourcis lorsque des fluctuations des valeurs mesurées de la température du fluide sont importantes, tandis que lesdits cycles de calcul sont allongés lorsque des fluctuations des valeurs mesurées de la température du fluide sont faibles.

6. Procédé de mesure d'une contrainte thermique dans un tube soumis à une pression, le procédé comportant les étapes consistant à calculer la répartition de température en des emplacements équidistants dans une direction le long de l'épaisseur dudit tube en fonction de valeurs mesurées sur les surfaces d'une partie de métal dudit tube; et à calculer la contrainte thermique de la partie de métal dudit tube.

7. Procédé selon la revendication 6, dans lequel lesdites valeurs mesurées sont des valeurs mesurées des températures superficielles internes et externes du métal dudit tube.

8. Procédé selon la revendication 6, dans lequel lesdites valeurs mesurées sont des valeurs mesurées de la température, de la pression et du débit du fluide dans ledit tube, et une valeur mesurée de la température superficielle externe du métal dudit tube.

9. Procédé selon la revendication 6, 7 ou 8, dans lequel ledit tube soumis à une pression est situé sur une chaudière.

10. Procédé selon l'une quelconque des revendications 6 à 9, comportant en outre l'étape consistant à prédéterminer des cycles de calcul en fonction de valeurs mesurées de la température du fluide dans ledit tube soumis à une pression; dans lequel lesdits cycles de calcul sont raccourcis lorsque des fluctuations des valeurs mesurées de la température du fluide sont importantes, tandis que lesdits cycles de calcul sont allongés lorsque des fluctuations des valeurs mesurées de la température du fluide sont faibles.
